# EUROPEAN PATENT APPLICATION

(11) **EP 1 085 112 A2**
(43) Date of publication of application: **21.03.2001**
(21) Application number: 00120501.2
(22) Date of filing: 19.09.2000
(51) Int. Cl.: C30B 15/30, C30B 11/00

(54) **Method of fabricating a single crystal**

(30) Priority: 20.09.1999 JP 26552199
(71) Applicant: Union Material Inc., Kitasoma-gun, Ibaraki 300-16 (JP); Shikoku Instrumentation Co., Ltd., Kagawa 764-8502 (JP)
(72) Inventor: Sakuragi, Shiro, Kitasoma-gun, Ibaraki 300-1622 (JP); Taguchi, Yutaka, 3-17-1, Tsukuba-shi, Ibaraki 300-2635 (JP)
(74) Representative: Liesegang, Roland, Dr.-Ing.

(57) **Abstract**

An apparatus for fabricating a crystal is provided with a vessel 1 for accommodating a melt 3,with heaters 2 disposed in a bilaterally symmetrical manner on two sides thereof.A section through the front elevation of the vessel 1 has a shape that is bilaterally symmetrical.If a temperature gradient is formed by heaters 2 in a state in which the melt 3 of the crystal is supplied into the vessel 1,in such a manner that the upper part of the vessel 1 is at a high temperature and the lower part thereof is at a low temperature,the high-temperature melt will rise along the inner wall surfaces of the circular section of the vessel 1.A plane surface comprising a vertical line(a "mirror-symmetry plane")11 divides the vessel 1 into two parts vertically,in such a manner that left-side part of the melt rises in the clockwise direction and a right-side part thereof rises in the counterclockwise direction.The melt having this bilaterally symmetrical flow pattern strikes the miror-symmetry plane 11 at the upper end of the vessel 1,whereupon the two parts thereof flow downward towards the low-temperature region in the lower end of the vessel 1.A single crystal is formed as the temperature at the lower end of the vessel 1 is gradually lowered below the melting point of the melt material.

## Description

### TECHNICAL FIELD

The present invention relates to a method of fabricating a single crystal, and, in particular, to a method to fabricate a single crystal of a complex shape without necessitating any cutting or grinding steps.

### BACKGROUND OF THE INVENTION

Various generic methods are known in the art for fabricating a single crystal, including pull-up methods (such as the Czochraliski process) and pull-down methods (such as the Bridgman technique). With a pull-up method, the material that is to form the single crystal is first placed into a crucible made of a material such as quartz or carbon and is heated to form a melt. A single-crystal ingot is then fabricated by inserting a seed crystal into the melt and rotating it therein, then gradually pulling it upward. A pull-down method uses a furnace having a suitable temperature gradient, wherein a single-crystal ingot is fabricated by causing a melt to solidify from a lower end portion of a vessel containing the melt, either by moving the vessel downwardly or by reducing the temperature of the furnace.

Since the single crystal fabricated by either of the above described two methods is in the form of an ingot, it is necessary to cut and grind the ingot to obtain products of a specific shape. This necessitates a cutting apparatus and a grinding apparatus, and also requires some work. In addition, a certain amount of crystal is discarded at each step, which wastes materials.

Furthermore, the cut section may be damaged during the cutting, leading to deterioration of the crystal quality. To counter this problem, it is necessary to grind the surface that has been damaged by the cutting, to remove the damaged surface portions which increases the cost.

The present invention was made in the light of the above-described difficulties with the prior art to solve the technical problem to provide a method of fabricating a single crystal that makes it possible to create a product of predetermined shape without requiring any cutting step or a grinding step to remove a damaged surface.

### SUMMARY OF THE INVENTION

This problem is met by a method according to claim 1 and an apparatus according to claim 4.

The present invention makes it possible to fabricate a high-quality single crystal having a predetermined shape corresponding to the inner shape of the vessel without performing any cutting step or grinding step to remove damaged surfaces.

### BRIEF DESCRIPTION OF THE DRAWINGS

Fig. 1a and 1b illustrate the principle of the present invention;
Fig. 2 is a cross-sectional view of the front elevation of a conceptual apparatus for implementing the single crystal fabrication method in accordance with an embodiment of the invention;
Fig. 3a, 3b and 3c are illustrative views similar to Fig. 2 of process steps of fabricating a crystal using the apparatus of Fig. 2;
Fig. 4a and 4b are cross sections located perpendicular to each other through the vessel of Figs. 2 and 3 showing details of the vessel and a view of the single crystal fabricated therein;
Fig. 5a, 5b and 5c are cross sections similar to Fig. 4 through another configuration of the vessel and a crystal fabricated therein;
Fig. 6a, 6b and 6c are cross sections similar to Fig. 4 and 5 through a further configuration of the vessel and a crystal fabricated therein;
Fig. 7a to 7d illustrate yet another configuration of the vessel and crystals fabricated therein.

Embodiments of the present invention are described below with reference to the accompanying drawings.

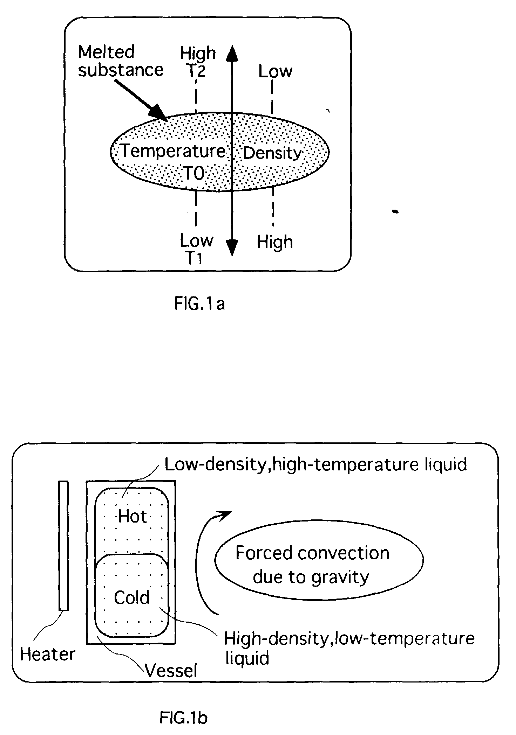

The description first concerns the principle of the present invention, with reference to Fig. 1. With most substances, if a temperature T0 at which such a substance is liquid is taken as a reference, the density of the liquid at a higher temperature T2 is lower than the density thereof at the temperature T0 and, conversely, the density of that liquid at a temperature T1 that is lower than that temperature T0 is greater than the density thereof at the temperature T0, as shown in Fig. 1a. If the force of gravity acts on a liquid having such a density difference, convection will occur as shown in Fig. 1b, and the liquid will be mixed thereby.

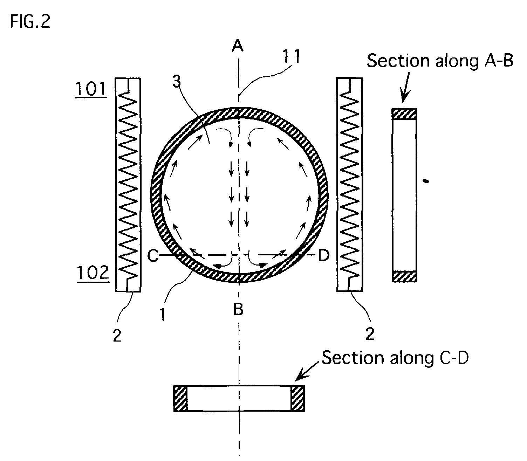

A section through the front elevation of a conceptual apparatus for implementing the single crystal fabrication method of one embodiment of this invention is shown in Fig. 2. This apparatus is provided with a vessel 1 for accommodating a melt 3 of a crystal material, with heaters 2 disposed symmetrically on the two sides thereof. A section through the front elevation of the vessel 1 has a shape that is bilaterally symmetrical. In the example shown in Fig. 2, the shape of the section through the front elevation is circular, but it could equally well be diamond-shaped or polygonal, such as rectangular, as will be described later. It should be noted, however, that a polygonal shape should be set in such a manner that there are vertices at the upper and lower ends thereof, to ensure the generation of mirror-symmetrical convection, as will be described later. If the section is circular, the thickness thereof is preferably no more than 50% of the diameter; if the section has a diamond or similar shape, the thickness thereof is preferably no more than 50% of the length along the line of symmetry.

If the state of the melt of crystal within the vessel 1 is as shown in Fig. 2 and a temperature gradient is formed by the heaters 2 in such a manner that the upper part of the vessel 1 is at a high temperature 101 and the lower part thereof is at a low temperature 102(except that both temperatures are above the melting point of the liquid 3), the high-temperature melt will rise along the inner wall surfaces of the circular section of the vessel 1. In Fig. 2, a plane surface comprising a vertical line (hereinafter called a "mirror-symmetry plane") 11 divides the vessel 1 into two parts vertically, in such a manner that a left-side part of the melt rises in the clockwise direction and a right-side part thereof rises in the counterclockwise direction. The melt having this bilaterally symmetrical flow pattern strikes the mirror-symmetry plane at the upper end of the vessel, whereupon the two parts thereof flow downward towards the low-temperature region in the lower end of the vessel. This flow is called mirror-symmetrical convection. In this case, the temperature at the lower end of the vessel 1 is gradually reduced to below the melting point of the melt material so that the melt solidifies, in other words, it crystallizes.

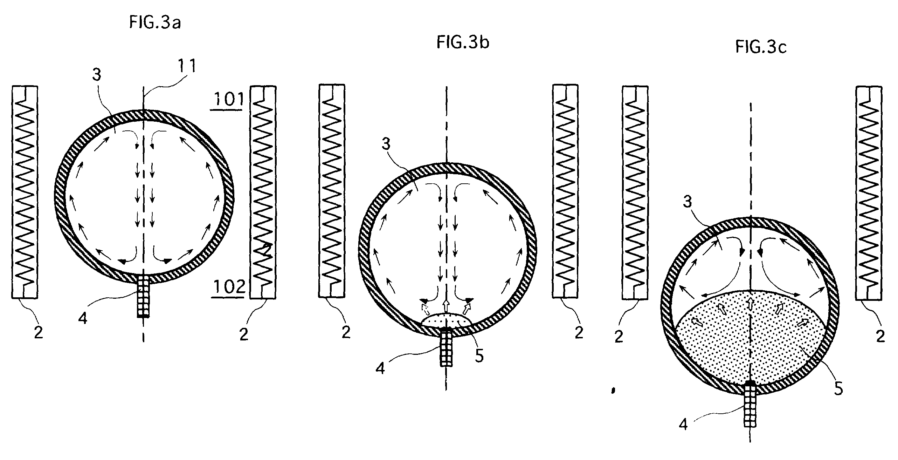

To produce crystallization in practice, a seed crystal 4 is disposed at the lower end of the vessel 1 as shown in Fig. 3a. If the vessel 1 is moved downward from this state, as shown in Fig. 3b, a single crystal will start to grow, centered on this seed crystal 4. A single crystal 5 can be made to grow gradually towards the upper part of the vessel 1, by moving the vessel 1 further downward, as shown in Fig. 3c. The characteristic of the invention in this case is that there is a strong tendency for the boundary surface between the melt 3 and the single crystal 5 to form a convex surface, since the melt within the vessel 1 forms a mirror-symmetrical flow pattern, making it easier for the single crystal to form. Note that the hollow arrows in Figs. 3b and 3c indicated the direction of growth of the crystal.

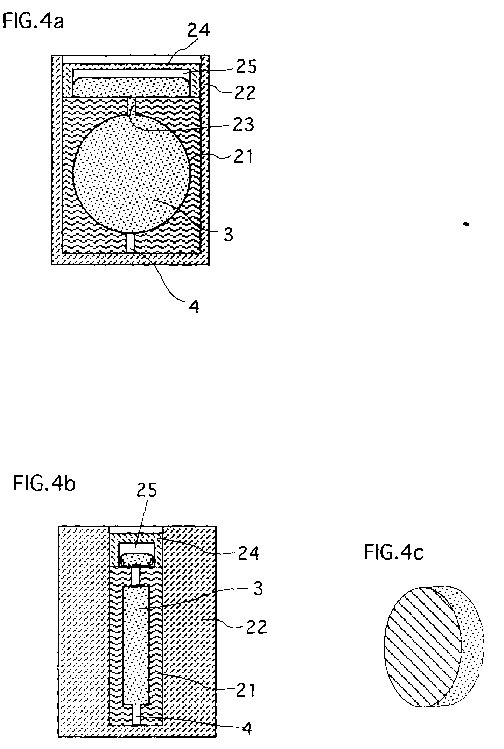

Details of the vessel 1 of Figs. 2 and 3 and a view of the single crystal that is fabricated thereby are shown in Fig. 4. In this case, Fig. 4a is a section through the front elevation, Fig. 4b is a section through a side elevation, and Fig. 4c is a perspective view of the resultant single crystal.

As shown in Figs. 4a and 4b, the vessel containing the melt 3 is configured of an inner vessel 21 and an outer vessel 22. The inner vessel 21 is provided with a space that accommodates the melt 3 therein. This space has a substantially circular plate form, a portion for the disposition of the seed crystal 4 is provided at a lower end thereof, and 1 passageway 23 for allowing any overflow of the melt 3 to escape is provided at an upper end thereof. An inner vessel lid 24 of a substantially U shaped section is placed within an upper surface of the inner vessel 21, to form a melt tank 25.

The seed crystal 4 is disposed in a portion below the space of the inner vessel 21 and also the material for the crystal is supplied into the space. During this time, a large enough quantity of the material is inserted to ensure that the melt 3 formed by melting the material overflows from the passageway 23 up into the melt tank 25. Heaters (not shown in the figure) are then operated to turn the crystal material into the melt 3 and also form a temperature gradient such that the upper portion is at a higher temperature and the lower portion is at a lower temperature, as shown in Fig. 2. During this time, the seed crystal 4 also melts. The outer vessel 22 is moved downward in a similar manner to that shown in Figs. 3b and 3c, to crystallize the melt 3. After the crystallization has ended, the inner vessel 21 is removed from the outer vessel 22, the inner vessel 21 is disassembled, and a circular-plate-form crystal such as that shown in Fig. 4c is removed therefrom.

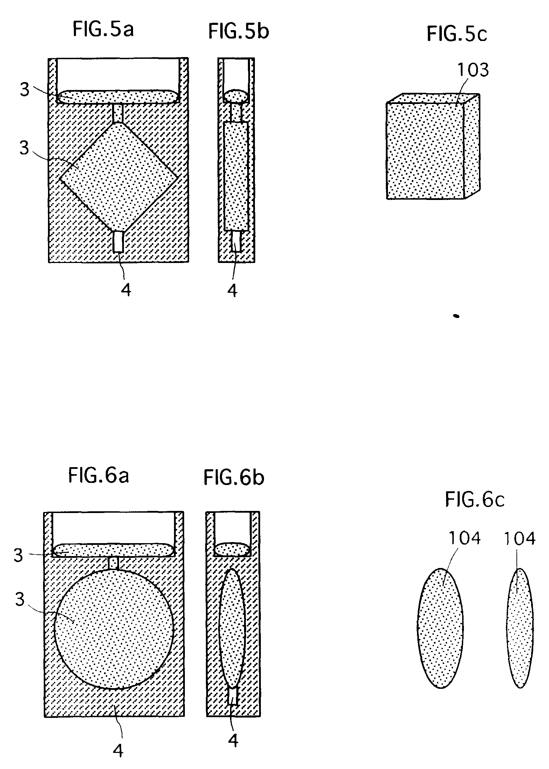

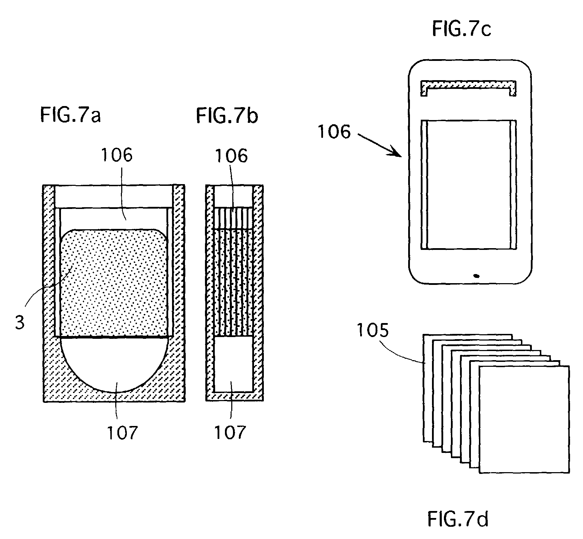

Various differently shaped crystals, such as a square-plate-form crystal 103, a convex lens-shaped crystal 104, or a thin-plate-form crystal 105, can be fabricated by varying the shape of the space within the inner vessel 21 and the configuration of the inner vessel 21 itself, as shown in Figs. 5, 6, and 7.
In this case,Fig.5a is a section through the front elevation.Fig.5b is a section through a side elevation,and Fig.5c is a perspective view of the square-plate-form crystal 103. Likewise, Fig.6a is a section through the front elevation,Fig.6b is a section through a side elevation, and Fig.6c is a side view of the convex lens-shaped crystal 104. Fig.7a is a section through the front elevation,Fig.7b is a section through a side elevation,Fig.7c is section and front view of a separater 106, and Fig.7d is a perspective view of the thin-plate-form crystal 105.

It should be noted, however, that since the lower end of the space that supplies the melt is flat in the configuration shown in Fig. 7, it is preferable that mirror-symmetrical convection is generated by melting approximately one-third of semi disc-shaped seed crystal 107.

The present invention that was described in detail above makes it possible to achieve the following effects (1) to (5):
(1) There is no cutting step, so there is no waste of resources due to the cutting apparatus, cutting time, cutting labor, or the cutting itself.
(2) There is no damage to surfaces due to cutting, so the quality of the product is improved.
(3) Selection of the shape of the space within the vessel (crucible) used for crystal growth enables the fabrication of crystals of various complex shapes, such as a circular plate shape, a square plate shape, a lens shape, or a thin plate shape.
(4) The formation of mirror-symmetrical convection ensures that the growth of the single crystal is facilitated and a high-quality single crystal is obtained thereby.
(5) Selection of the material of the crystal enables the fabrication of single crystals of an optical material such as calcium fluoride or of a semiconductor material such as germanium.

## Claims

1. A method of fabricating a single crystal wherein a single crystal is fabricated by generating mirror-symmetrical convection within a vessel (1) that accommodates a melt (3) of a crystal material, and gradually cooling said vessel from below.

2. Method of claim 1, **characterized** in that said vessel (1) has plane symmetry about a vertical plane and is provided with an internal space of a shape having an upper end and a lower end at positions on said plane.

3. Method of claim 2, **characterized** in that heaters (2) are disposed on outer sides of said vessel (1) on two sides of said plane surface (A-B),to cause the generation of said mirror-symmetrical convection by creating a temperature gradient which is high at an upper end and low at a lower end thereof.

4. Method of one of claims 1 to 3, **characterized** in that the inner shape of the vessel (1) corresponds to the outer shape of the crystal to be formed.

5. An apparatus of fabricating a single crystal comprising a vessel (1) having a space the inner shape of which corresponds to the desired outer shape of the crystal which contains a molten substance (3) for creating a crystal and a device (2, 2) to cause mirror-symmetrical convection flow of the substance within said vessel (1) with reference to a vertical symmetry plane (A-B), said symmetry plane dividing the space (3) within said ring into two mirror-symmetrical parts.

6. Apparatus of claim 4, **characterized** in that the vessel (1) is in the shape of a ring and the symmetry plane extends along a diameter of said ring.

7. Apparatus of claim 4 or 5, **characterized** in that the device comprises a pair of heaters (2, 2) arranged outside of opposite outer sides of said vessel (1).

8. Apparatus of claim 5, **characterized** in that the heaters (2, 2) have surfaces arranged parallel to said plane (A-B).
